# EUROPEAN PATENT APPLICATION

(11) **EP 2 068 605 A1**
(43) Date of publication of application: **10.06.2009**
(21) Application number: 08792602.8
(22) Date of filing: 21.08.2008
(51) Int. Cl.: H05K 3/46

(54) **PRINTED WIRING BOARD AND METHOD FOR MANUFACTURING THE SAME**

(30) Priority: 20.09.2007 US 973971 P; 19.11.2007 US 988887 P; 08.08.2008 US 188795
(71) Applicant: IBIDEN CO., LTD., Gifu 503-8604 (JP)
(72) Inventor: NIKI, Ayao, Ogaki-shi, Gifu 5038604 (JP); KITAJIMA, Kazuhisa, Ogaki-shi, Gifu 5038604 (JP)
(74) Representative: HOFFMANN EITLE
(86) International application number: PCT/JP2008/064881
(87) International publication number: WO 2009/037939

(57) **Abstract**

A printed wiring board, comprising: a plurality of resin insulation layers each having openings for via conductors; a plurality of conductive layers each having a conductive circuit; via conductors formed in the openings and connecting conductive circuits formed in separate conductive layers among the conductive layers; and a plurality of component-loading pad for loading an electronic component formed on an uppermost resin insulation layer positioned as an outermost layer of the plurality of resin insulation layers, wherein the resin insulation layers and the conductive layers are alternately laminated, and the component-loading pads are formed from a copper foil is provided.

## Description

### Technical Field

The present invention relates to a printed wiring board, more specifically, to a printed wiring board structured with alternately laminated conductive circuits and insulation layers and having pads on one surface of the board to load an electronic component such as an IC.

### Background Art

In recent years, as electronic devices become more highly functional, they are also required to be made smaller and thinner. Accordingly, electronic components such as IC chips and LSIs are becoming highly integrated at a rapid pace, and there are more demands for higher density in wiring and a larger number of terminals in package substrates to load such electronic components.

In order to respond to such demands, a method for manufacturing a printed wiring board with dielectric layers made of polymer material and conductive layers laminated alternately and having the above-described pads is disclosed, the method comprising the steps of: (a) preparing a metal foil adhesion body prepared by adhering two metal foils onto a base substrate, and forming a laminated-sheet body by alternately laminating a dielectric layer and a conductive layer on one surface of the metal foil adhesion body; (b) removing the peripheral portions of the laminated-sheet body to release the metal foil adhesion body from the base substrate, wherein one of the metal foils remains adhered to the laminated-sheet body; (c) patterning by covering a surface of the metal foil with a mask material so as to form an opening for the regions to form a metal-terminal pad; (d) forming an electroplating surface layer on the metal-terminal pads by electroplating treatment; and (e) removing the mask material, and then conducting an etching treatment of the metal foil by using the electroplating surface layer as an etching resist (see Patent Document 1).

Also, Japanese unexamined Patent Publication H10-41610 discloses a printed wiring board for mounting an IC chip; the printed wiring board is prepared by alternately laminating interlayer resin insulation layers and conductive layers on both surfaces of a substrate made of glass epoxy or the like.

[Patent Document 1] Japanese unexamined Patent Publication 2006-19591
[Patent Document 2] Japanese unexamined Patent Publication H10-41610

### Disclosure of the Invention

### Problem to be solved by the Invention

In a printed wiring board manufactured by the method according to Japanese unexamined Patent Publication 2006-19591 (hereinafter referred to as "Conventional Example 1"), an electroplating layer is formed on a metal foil by electroplating, and the electroplating layer is used as an etching resist to form a conductive circuit by etching. Then, the conductive circuit is used as pads for mounting a semiconductor element.

In the above manufacturing method, an electroplating layer formed on the pads is formed by electroplating. Regarding electroplating, the thickness of electroplating films differs depending on the density of a pattern or the position of pads (at the center or the edges of the base material) or other factors. Thus, the thickness of the electroplating layer differs on each pad. If the thickness of the electroplating layer on each pad differs, the distance between the electrode of an electronic component and the electroplating layer formed on the pad differs at each pad.

Since electronic components and a printed wiring board have a different coefficient of thermal expansion, it causes stress. Such stress is usually relieved by solder bumps for mounting electronic components. However, if the distance between an electronic component and pads differs at each pad, the stress tends to concentrate on certain solder bumps, thus causing deterioration by fatigue in those solder bumps. As a result, the yield from mounting electronic components and the mounting reliability will be lowered.

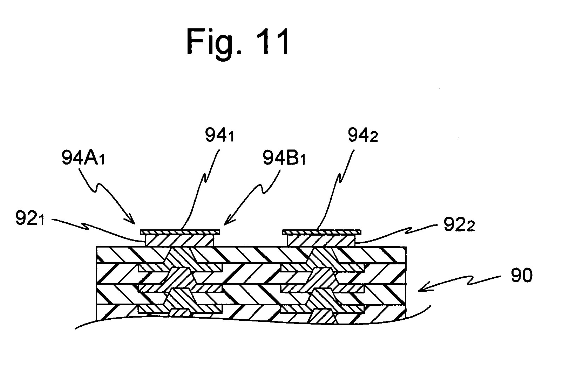

In the method described in Conventional Example 1, electroplating layers 94₁ and 94₂ are used as etching resists for forming pads 92₁ and 92₂. Accordingly, portions 94A₁ and 94B₁ of the electroplating layer have overhang from the pad (see Fig. 11). The overhang portions 94A₁ and 94B₁ of the electroplating layer are not anchored at a conductive circuit 92₁ as a basis. Thus, those portions move relatively freely, and fatigue break tends to occur easily. Then, with the fatigue break as a starting point, problems such as cracks in the bumps formed on the pads tend to occur easily.

Further, if a solder bump is formed on an electroplating layer 94₁, on the portions 94A₁ and 94B₁ of the electroplating layer overhanging from pad 92₁, the solder bump is formed as well. Since the solder bump formed on those portions is not anchored on the pad the same way as in the electroplating layer, the solder bump may easily move. Therefore, problems such as cracks in the solder bump itself or its underfill may occur, and an electronic component such as an IC may be easily damaged.

In the method described in Conventional Example 1, as a metal foil adhesion body, for example, two sheets of copper foil adhered each other via a metal plating layer ( for example, Cr plating layer) is used. However, in the metal foil adhesion body, bonding strength between the two sheets of metal foil is weak. Therefore, during thermal processing and others conducted in the manufacturing process of the printed wiring board, the bonded metal foil may be separated between them. Then, as of the separation generated between them, the metal foil on the adhesion body is peeled from the support member on the adhesion body, and it sometimes generates a bubble between them, to be soaked up with the plating solution or the like. Furthermore, since the bonding strength between two sheets of foil is weak, the metal foil adhered on the printed wiring board may be fractured or broken when wiring layer is formed by using the build-up process on the metal foil adhesion body.

A printed wiring board disclosed in Japanese unexamined Patent Publication H10-41610 (hereinafter referred to as "Conventional Example 2") has a substrate, which causes the printed wiring board to thicken. Therefore, a printed wiring board that is thinner, more stable and lasts longer for mounting an electronic component such as an IC is required.

### Means for Solving the Problem

The printed wiring board of the present invention is a printed wiring board, comprising: a plurality of resin insulation layers each having openings for via conductors; a plurality of conductive layers each having a conductive circuit; via conductors formed in the openings and connecting conductive circuits formed in separate conductive layers among the conductive layers; and a plurality of component-loading pad for loading an electronic component formed on an uppermost resin insulation layer positioned as an outermost layer of the plurality of resin insulation layers, wherein the resin insulation layers and the conductive layers are alternately laminated, and the component-loading pads are formed from a copper foil.

Here, the component-loading pads is preferred to have a frustum form, in which an area of a bottom surface touching a surface of the uppermost resin insulation layer is made larger than the area of a top surface. Furthermore, on the upper surface of the component-loading pads, an electronic component is mounted, and on the side surface of the component-loading pads, solder members are preferred to be formed. Also, the side surfaces of the component-loading pads are preferred to be roughened.

In addition, in the printed wiring board, on the uppermost resin insulation layer, it is preferred that a conductive circuit drawn from the pad toward the periphery of a resin insulation layer on the substrate is not formed on the uppermost resin insulation layer. Furthermore, it is preferred that the component-loading pads arranged on the uppermost resin insulation layer be formed in a pad-forming region, and that in the region excluding the pad-forming region the surface of the uppermost resin insulation layer be exposed.

Moreover, on the upper surface and side surface of the component-loading pad, a protective film is preferred to be formed, and the interlayer resin insulation layers are preferred to be insulation layers containing filler except a glass cloth and a continuous glass fiber.

In the printed wiring board, it is preferred that the component-loading pads comprise a component-loading pad for a power supply and a component-loading pad for ground; and in the pad-forming region for forming component-loading pads, at least one inner conductive circuit selected from a group consisting of the circuit for power supply that electrically connects each component-loading pad for power-supply and the circuit for ground that electrically connects each component-loading pad for ground is formed.

The present invention is also a method for manufacturing a printed wiring board, comprising the steps of: securing a metal foil to a support member by joining or bonding,; forming a resin insulation layer on the metal foil; forming an opening for a via conductor in the resin insulation layer; forming a conductive circuit on the resin insulation layer; forming a via conductor that electrically connects the conductive circuit and the metal foil in the opening; separating the support member and the metal foil; and forming an external terminal from the metal foil, wherein the terminal electrically connects to a different board or an electronic component.

Here, the conductive circuit and the via conductor are preferably formed simultaneously, and the metal foil is preferably secured by joining or bonding its peripheral portions to the support member.
In the method for manufacturing a printed wiring board of the present invention, it is preferred to further comprise the steps of: forming an upper-layer resin insulation layer on the resin insulation layer and conductive circuit; forming an opening for forming an upper-layer via conductor in the upper-layer resin insulation layer; forming an upper-layer conductive circuit on the upper-layer resin insulation layer; and forming an upper-layer via conductor in the upper-layer openings, wherein the via conductor electrically connects the conductive circuit and the upper-layer conductive circuit. The upper-layer conductive circuit and the via conductor is preferably formed simultaneously.

The support member is preferably a metal plate member or a plate member composed of a support base member and a metal covering a surface of the support base member. Here, the 'support base member' is defined as the member used for covering its surfaces with a metal to form the support member. Concretely, it includes the plate type member which is made of glass-epoxy resin or other polymer resin. Here, the metal is preferably made of metal foil, and it is preferably secured with the support member by ultrasonic bonding. Furthermore, the support member is preferably a copper-clad laminate, and it is preferably secured with the metal foil by ultrasonic bonding.

### Effect of the Invention

By employing the above-mentioned constitution, the height of each first pad becomes substantially uniform. As a result, the distance between those pads and the electrodes of an electronic component may be made substantially equal. Thereby, the concentration of the stresses to certain bumps may be avoided, and it may improve the connection reliability.

Also, since the distance between each electrode of an electronic component and each first pad corresponding to each electrode of the electronic component is made equal, the amount of solder to be used to connect them may be reduced. Accordingly, the connection resistance between the electronic component and the printed wiring board may be lowered, thus malfunctions of the electronic component may be prevented. Furthermore, since the amount of solder is reduced, when mounting the component (solder-reflowing), the amount of heat applied on the printed wiring board may be reduced.

### Brief Description of the Drawings

[Fig. 1A] Fig. 1A is a cross-sectional view of a printed wiring board of the present invention.
[Fig. 1B] Fig. 1B is a plan view of a printed wiring board of the present invention.
[Fig. 2A] Fig. 2A is a view illustrating a step for manufacturing a printed wiring board of the present invention (step 1).
[Fig. 2B] Fig. 2B is a view illustrating a step for manufacturing a printed wiring board of the present invention (step 2).
[Fig. 2C] Fig. 2C is a view illustrating a step for manufacturing a printed wiring board of the present invention (step 3).
[Fig. 2D] Fig. 2D is a view illustrating a step for manufacturing a printed wiring board of the present invention (step 4).

[Fig. 3A] Fig. 3A is a view illustrating a step for manufacturing a printed wiring board of the present invention (step 5).
[Fig. 3B] Fig. 3B is a view illustrating a step for manufacturing a printed wiring board of the present invention (step 6).
[Fig. 3C] Fig. 3C is a view illustrating a step for manufacturing a printed wiring board of the present invention (step 7).
[Fig. 4A] Fig. 4A is a view illustrating a step for manufacturing a printed wiring board of the present invention (step 8).
[Fig. 4B] Fig. 4B is a view illustrating a step for manufacturing a printed wiring board of the present invention (step 9).

[Fig. 5A] Fig. 5A is a view illustrating a step for manufacturing a printed wiring board of the present invention (step 10).
[Fig. 5B] Fig. 5B is a view illustrating a step for manufacturing a printed wiring board of the present invention (step 11).
[Fig. 6A] Fig. 6A is a view illustrating a step for manufacturing a printed wiring board of the present invention (step 12).
[Fig. 6B] Fig. 6B is a view illustrating a step for manufacturing a printed wiring board of the present invention (step 13).

[Fig. 7A] Fig. 7A is a view illustrating a step for manufacturing a printed wiring board of the present invention (step 14).
[Fig. 7B] Fig. 7B is a view illustrating a step for manufacturing a printed wiring board of the present invention (step 15).
[Fig. 8A] Fig. 8A is a view illustrating a step for manufacturing a printed wiring board of the present invention (step 16).
[Fig. 8B] Fig. 8B is a view illustrating a step for manufacturing a printed wiring board of the present invention (step 17).
[Fig. 8C] Fig. 8C is a view illustrating a step for manufacturing a printed wiring board of the present invention (step 18).

[Fig. 9] Fig. 9 is a schematic view (view 1) illustrating pads arranged on the outermost layer of a printed wiring board of the present invention and wiring between the pads.
[Fig. 10] Fig. 10 is a schematic view (view 2) illustrating a pad-forming region arranged on the outermost layer of a printed wiring board of the present invention, pads formed in the pad-forming region, and wiring between the pads.
[Fig. 11] Fig. 11 is a cross-sectional view illustrating a printed wiring board and pads manufactured by a conventional method.

### Best Mode for Carrying Out the Invention

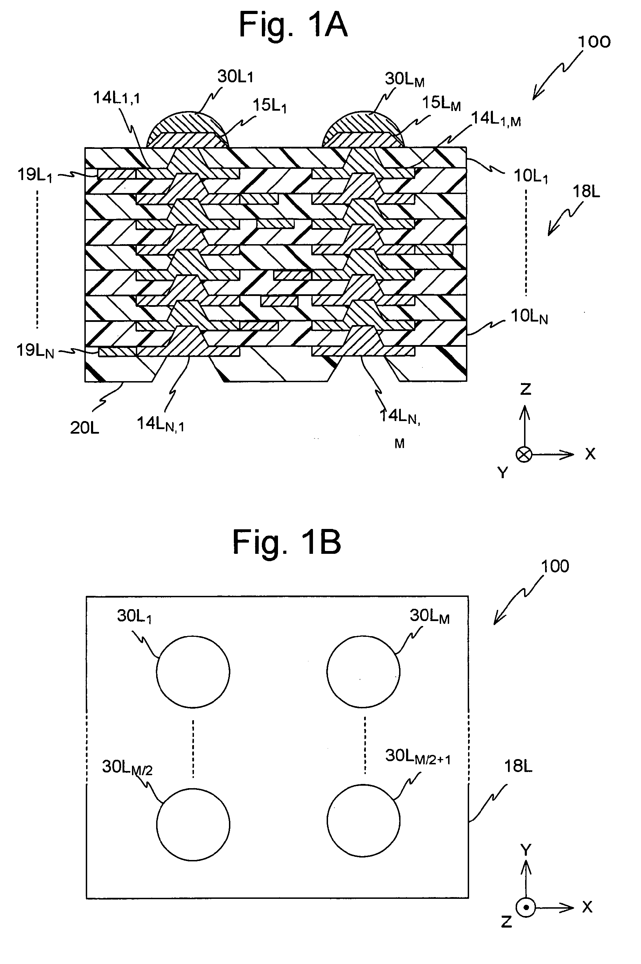

In the following, referring to Figs. 1-10, a detailed description of a printed wiring board according to the present invention is provided as an embodiment. Also, with reference to Figs. 1-8, an embodiment is described in which via conductors described below are formed in two columns. In the following description and drawings, the same or an equivalent element is indicated by the same reference code and a duplicate description is omitted.

As shown in Fig. 1A, a printed wiring board 100 of this embodiment comprises (a) a laminate 18L, wherein a resin insulation layer 10Lᵢ (j=1∼N) and a conductive layer with a conductive circuit (a conductive pattern) 19Lᵢ are laminated alternately, and a via conductor for interlayer connections to connect the conductive circuits formed in the separate conductive layers (including the via conductors 14L_{1,1} to 14L_{N,M} corresponding to the first pads 15Lₖ (k=1∼M) described below), (b) the first pad (the first external connection terminal) 15Lₖ formed on the surface positioned in the (+Z) direction of the laminate 18L (the first surface of the uppermost resin insulation layer 10L₁; and (c) a solder member (a solder bump) 30Lₖ formed on the pad 15Lₖ. Also, the printed wiring board 100 has (d) a solder resist 20L formed on the surface in the (-Z) direction (the second surface of the lowermost resin insulation layer) of the laminate 18L.

As shown in Fig. 1B, in the printed wiring board 100, the first pad 15Lₖ on which the solder member 30Lₖ is formed is arranged two-dimensionally on the first surface of the uppermost resin insulation layer 10L₁ to form a pad group.

Also, the solder resist has a plurality of openings. The opening partially opens the surface of a conductive circuit 19L_{N} formed on the second surface of the lowermost resin insulation layer, or the surfaces of the via conductor. The opening formed in the solder resist may also partially opens the surfaces of the via conductor and a portion of the conductive circuit (a via land) connected to the via conductor. The portion of the conductive circuit (the lowermost conductive circuit) or the portion of the via conductor exposed through the opening become the second pad (the second external connection terminal). Here, the first surface of each resin insulation layer indicates the surface where the first pad are formed; and the second surface of each resin insulation layer indicates the opposite surface, where the second pad are formed.

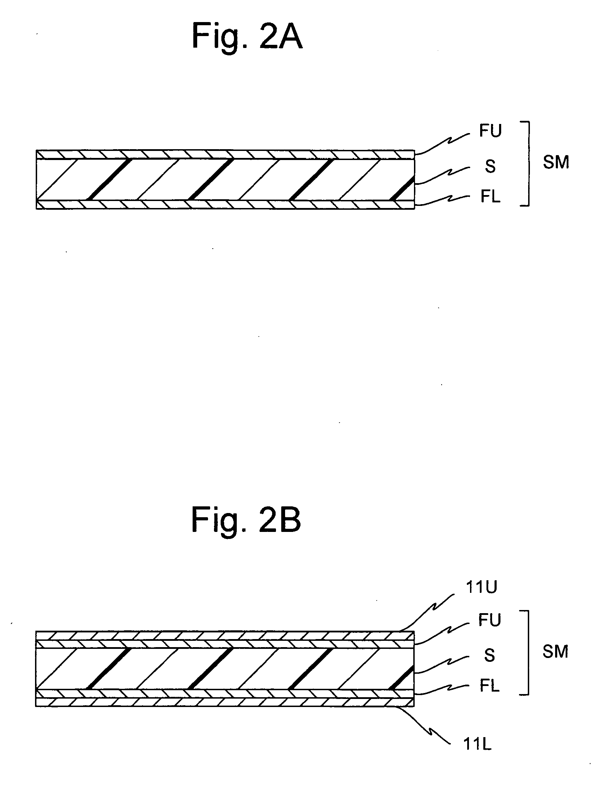

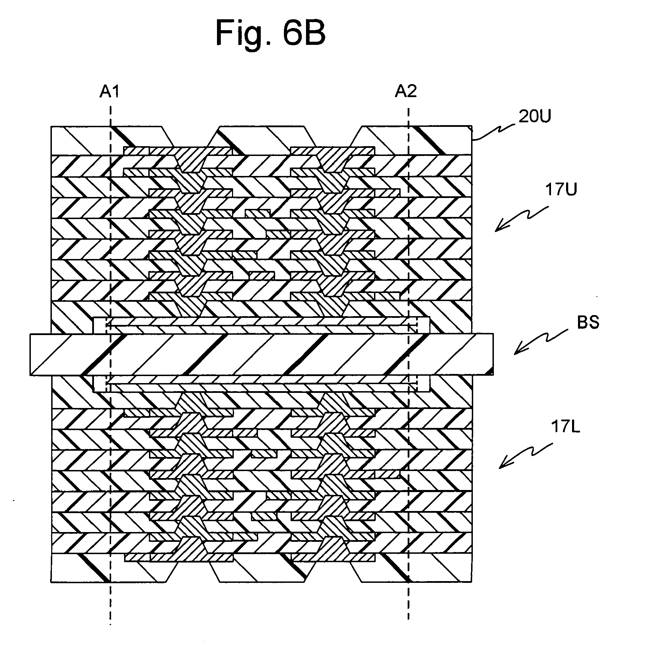

As shown in Fig. 2A, the laminate 18L is formed on a support member (hereinbelow it is referred to as a "support board") SM by an additive method or a subtractive method. On the outermost layer, the solder resist 20L or 20U is formed (see Fig. 6B), then, at a predetermined position the laminate is cut to be released from the support member SM.

Through the releasing process, the outermost resin insulation layer opposite where the solder resist 20U or 20L is formed becomes uppermost resin insulation layer 10U₁ or 10L₁. From the metal foil formed on the first surface of the uppermost resin insulation layer (the surface facing the support member SM, the surface of the printed wiring board to be exposed to the outside), component- loading pads (the first external connection terminal) 15L₁ to 15L_{M} are formed (see Figs. 1A and 1B).

The component-loading pads are preferred to be truncated as the frustum shape and in the X-Z cross-sectional view, as shown in Fig. 1A, the area of the bottom surface which is in contact with the uppermost resin insulation layer 10L₁ is larger than that of the upper surface where an electronic component will be mounted.

A protective film is formed by an electroless deposition or the like on the component-loading pads after the pads are formed. Accordingly, peripheral portions 94A₁ and 94B₁ of the protective film will not have overhang from the first pad (see Fig. 11).

The solder member is formed on the truncated frustum shape pad to cover the top and side surfaces of the first pad (see Fig. 1A).

Next, the manufacturing an electronic component having the constitution described above is explained with reference to the material of each element. Firstly, the support member SM is prepared (see Fig. 2A). The support member SM is composed of laminating conductive layers FU and FL on both surfaces of an insulation material S. The conductive layers FU and FL to structure the support member SM are a metal foil with a thickness of approximately a few µm to dozens of µm. As such, on the surfaces of the support member (a support plate), metal layers are preferred to be formed. From the point of forming a uniform thickness, the metal layers are more preferably made of metal foil.

As for the support member SM, the member having the conductive layers with the thickness secured by adhesives or the like on the surfaces of insulation material S may be used.

As for the insulation material S, for example, a glass-based laminate impregnated with a bismaleimide-triazine resin, a glass-based laminate impregnated with a polyphenyleneether resin, or glass-based laminate impregnated with a polyimide resin may be used. On both surfaces of such material, the metal foil such as a copper foil may be secured by using a well-known method.

Also, a commercially available double-sided copper-clad laminate or single-sided copper-clad laminate may be used. As for such a commercially available laminate, for example, "MCL-E679 FGR" (made by Hitachi Chemical Co., Ltd., located in Shinjuku, Tokyo) may be listed. Concretely, the base composed of the 0.2 to 0.6 mm thickness of glass-epoxy laminate 11 and 3 to 20 µm thickness of copper foil 12 which is adhered on the both side of the base may be used. Alternatively, as for the support member SM, a metal plate may also be used.

Then, as shown in Fig. 2B, the first surface of metal foil 11U or 11L is laminated on the conductive layer FU or FL so as to face either the conductive layer FU or FL. As for the metal foil, for example, the copper foil, a nickel foil or a titanium foil, each of them having a desirable thickness, may be used. The second surface of such metal foil, opposite the first surface, is preferred to be a matted surface. For example, when using the copper foil as the metal foil 11U or 11L, it is preferred to use that having the thickness of approximately 3 µm to approximately 35 µm.

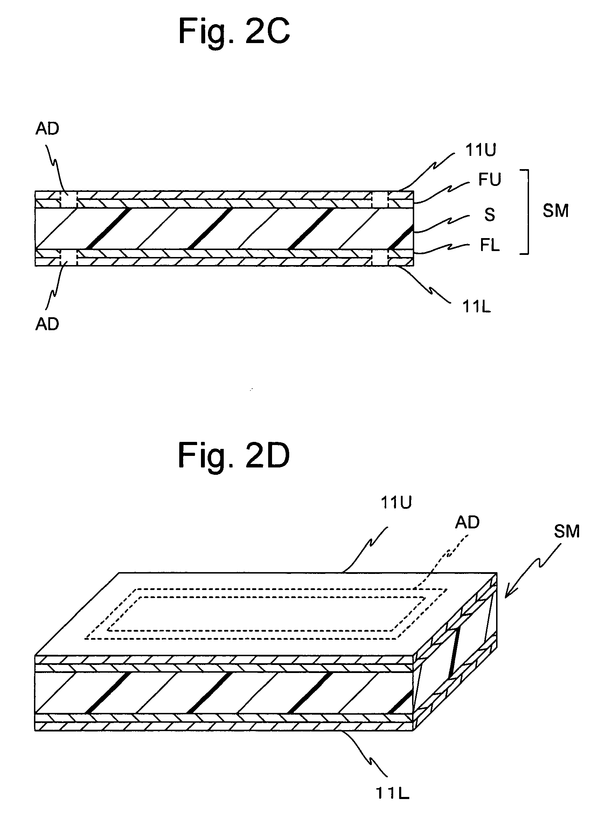

Next, as shown in Figs. 2C and 2D, the conductive layer FU or FL and the metal foil are preferred to be secured to each other by joining or bonding the peripheral portions of the support member SM (the portions indicated as "AD"). In the present embodiment, the portions of the conductive layer and the metal foil to be secured are preferably approximately 10 to approximately 30 mm inside from the edges of the metal foil toward the center portion. More preferably, the portions are approximately 20 mm inside from the edges. Also, it is preferred that both are secured approximately 1 to approximately 5 mm wide, and more preferably approximately 2 mm in width.

The conductive layer (the support plate) and the metal foil may be secured, for example, by using ultrasonic sound or an adhesive agent. Ultrasonically- securing is superior in regard to bonding strength and convenience. When by using ultrasonic sound bonding equipment, for example, securing at the desirable portions, which are positioned from the edges of the support member SM as described above, with the desirable width and shape may be conducted. As long as the conductive layer and the metal foil are removed without trouble at the releasing step described below, securing in a rectangular shape (see Fig. 2D) or a grid (not shown in the drawing) may be employed.

By securing the conductive layer and the metal foil, when forming an interlayer resin insulation layer or conductive layer described below, the following trouble may be prevented from occurring. When forming the resin insulation layer, the resin insulation layer repeatedly expands and shrinks depending on repetitive heating and standing to cool. Since the resin insulation layer is formed on the metal foil, the metal foil also repeats expansion and shrinkage following the resin insulation layer. As a result, distortion or deflection may easily occur in the metal foil. Also, substantial distortion or deflection may cause fracturing or bending, and thus the metal foil may be damaged. On the other hand, by securing the conductive layer and metal foil, such trouble may be prevented from occurring.

Also, when forming a conductive layer by using a plating process, the occurrence of the following trouble may be prevented as well. In plating, a substrate should be immersed in a solution such as a plating solution. In such a case, unless the conductive layer and the metal foil are secured, the plating solution is soaked up between them, which may cause soak off them. On the other hand, securing the conductive layer and the metal foil enables to avoid such a problem.

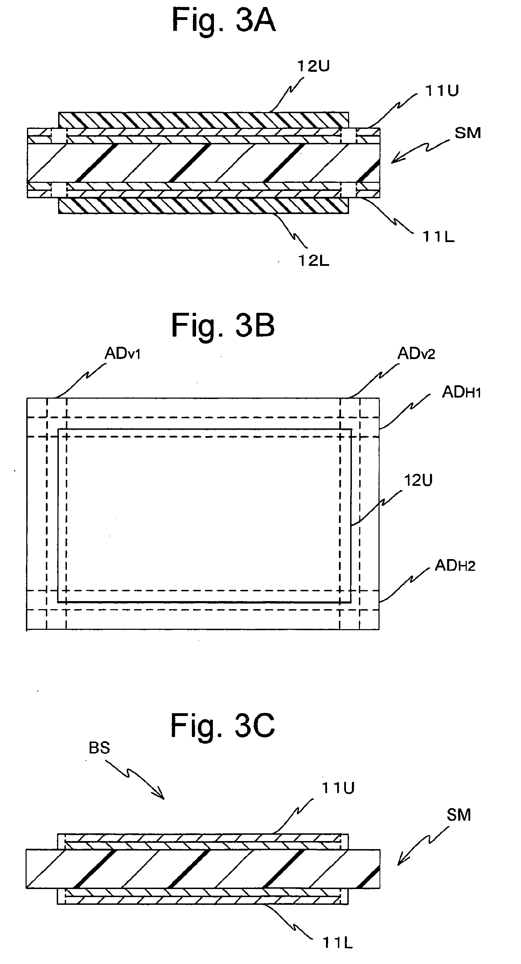

Next, as shown in Figs. 3A and 3B, to an adherent region AD, etching resists 12U and 12L are formed. Fig. 3B is a plan view of the laminated sheet body after the etching resist 12U is formed. The etching resist 12U is formed so as to partially overlap ultrasonic joining portions AD. In order to form such a resist, a commercially available dry film resist or a liquid resist may be used.

Then, peripheral portions of the conductive layers FU and FL, and the metal foils 11 U and 11L, which are positioned at the edges of the support member, are removed respectively by etching or the like using a well-known method. After that, by conventional procedure, the etching resist is removed (see Fig. 3C).

Each second surface of two sheets of metal foil 11U and 11L is preferred to be made matted, not smooth, and if desired, it may be roughened. If the second surface of the metal foil is smooth, it is preferred to be roughened to enhance adhesiveness with the resin insulation layer described below. For such a roughening treatment, a black oxide treatment using an alkaline solution or etching using a proper etching solution may be conducted. As for the etching solution, the micro etching solution "CZ series" (made by Mec Co., Ltd., located in Amagasaki, Hyogo) or the like may be used. Accordingly, the base substrate BS is formed (see Fig. 3C).

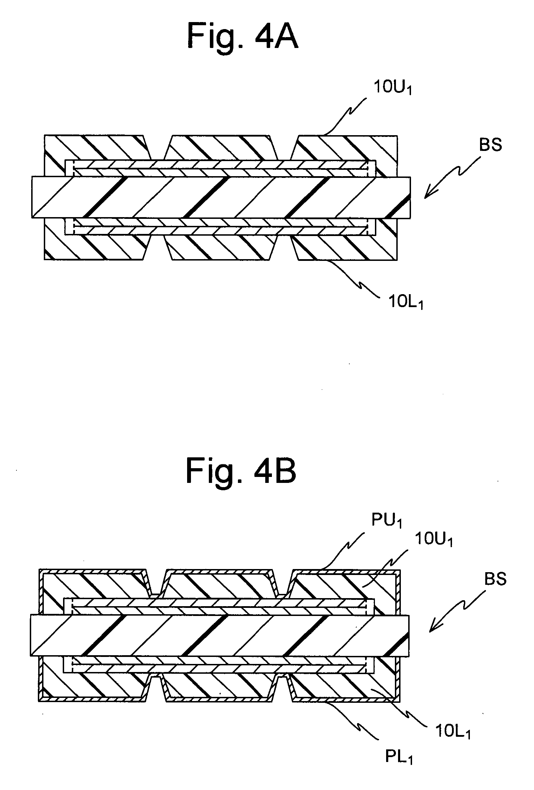

Next, to form a resin insulation layer on each second surface (the matted surface) of the sheets of the metal foil 11U and 11L which are laminated on the base substrate BS, the first surface of the resin insulation layer 10U₁ and 10L₁ is laminated to contact with the substrate (see Fig. 4A). As for the resin insulation layer, a film for the interlayer insulation or a half-cured resin sheet such as prepreg or others may be used. Instead of using the half-cured resin sheet, the resin insulation layer may be formed by screen-printing a uncured liquid resin on the metal foil. Either way, through thermosetting, the interlayer resin insulation layer (the uppermost resin insulation layer 10L₁ or 10U₁) is formed (see Fig. 4A).

As a film for such interlayer resin insulation, for example, the interlayer film for build-up wiring boards, "ABF series" (made by Ajinomoto Fine-Techno Co., Inc., located in Kawasaki, Kanagawa), may be listed. As for prepreg, varieties of products made by Hitachi Chemical Co., Ltd. may be used.

The thickness of the resin insulation layer is preferred to be made in the range from approximately 30 µm to approximately 100 µm. Among the resin insulation layers, at least one of them is preferably formed with a resin and a filler (except a glass cloth and a continuous glass fiber). Especially, if the printed wiring board 100 contains five or more resin insulation layers, all the resin insulation layers preferably contain the filler (except the glass cloth and the continuous glass fiber). As for the filler, inorganic filler is preferred, and if the glass fiber is used, it is preferred to be made of short fiber.

If the printed wiring board 100 contains four or fewer resin insulation layers, among all the resin insulation layers, one or two are preferably resin insulation layers containing a core material, such as the glass cloth or the continuous glass fiber, and the resin; and the remaining resin insulation layers are preferably resin insulation layers containing filler, except the glass cloth and the continuous glass fiber, and the resin.

Next, as shown in Fig. 4A, in the resin insulation layers 10U₁ and 10L₁, openings for via holes are formed by a laser. As for the laser to be used for forming openings, a carbon dioxide gas laser, an excimer laser, a YAG laser, a UV laser and the like may be listed. When forming openings by the laser, a protective film such as PET (polyethylene terephthalate) film may be used.

Next, in order to improve adhesiveness with the conductive layer, the surface of the resin insulation layer is preferred to be roughened. The surface of the resin insulation layer is roughened, for example, by immersing it in a potassium permanganate aqueous solution. Then, catalytic cores are formed on the surface of the resin insulation layer.

Then, as shown in Fig. 4B, by using a commercially available plating bath, thin electroless deposition films PU₁ and PL₁ with a thickness of approximately a few µm are formed. As the electroless deposition films formed here, electroless copper-deposition films are preferred.

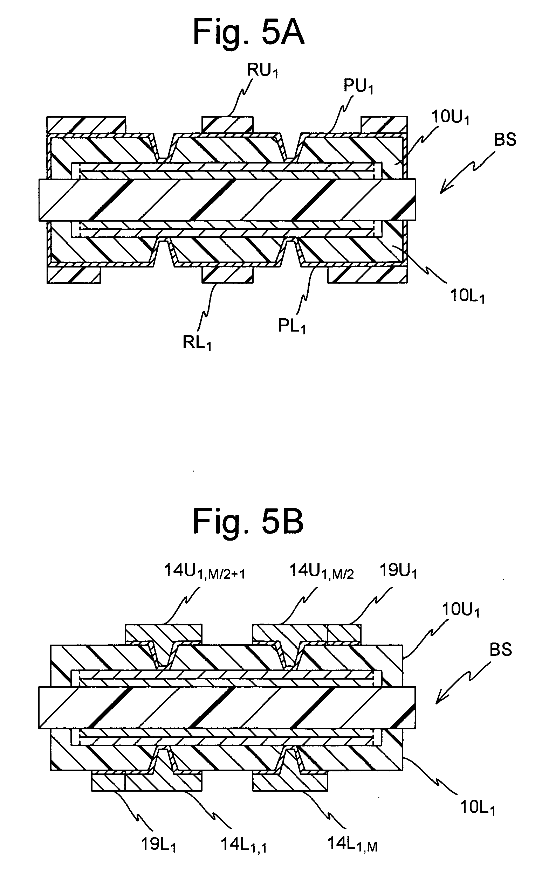

Next, as shown in Fig. 5A, on the electroless deposition films, plating resist patterns RU₁ and RL₁ are formed. The plating resist patterns RU₁ and RL₁ are formed on the areas excluding the via-conductor forming region and conductive-circuit forming region described below, and they may be formed, for example, by laminating the dry film for the plating resist, exposing it to light and then developing the pattern.

Next, electroplating is performed to form electroplating films with a thickness of approximately 5 to approximately 20 µm in the area, in which the plating resists are not formed. By this, conductive circuits and via conductors are formed. The via conductors to be formed here are preferred to be so-called filled via conductors, namely via conductors filled in the openings formed in the resin insulation layers. Also, the top surfaces of the via conductors are preferably positioned on the same level with those of the conductive pattern formed on the same resin insulation layer.

Next, the plating resists are removed. Then, as shown in Fig. 5B, since the electroless deposition films is exposed by the removal of the resist pattern, the exposed area of the plating films are removed to form the conductive circuits 19U and 19L, as well as the via conductors 14U and 14L. Here, the electroless deposition films may be removed by etching without using etching resist (hereinafter, it is sometimes referred to as "quick etching"), because the electroless deposition films are thin.

Such quick etching may be conducted, for example, by using an etching solution composed of hydrogen peroxide/sulfuric acid system.

Through the above steps, the first-layer resin insulation layer (the uppermost resin insulation layer), the first-layer conductive layer and via conductors are formed (see Fig. 5B). Here, the first-layer conductive circuit is formed on the second surface of the uppermost resin insulation layer. The surfaces of the conductive pattern (the conductive circuit) and the via conductors are preferred to be roughened.

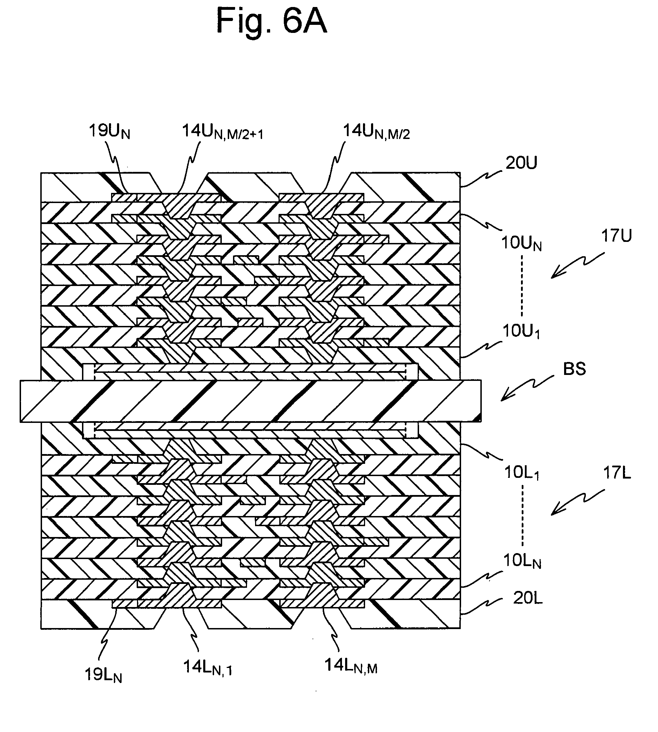

Next, in order to form the second-layer resin insulation layer, the first surface of the above-described half-cured resin sheet is laminated on the second surface of the uppermost resin insulation layer and on the first conductive layer. Subsequently, by repeating the steps shown from Fig. 4A to Fig. 5B, the second-layer resin insulation layer and the second-layer conductive layer and the via conductors are formed. Likewise, the steps from forming the resin insulation layer to forming the via conductors and the conductive pattern are repeated to obtain the laminated sheet body 17U and 17L, where a desirable number of the resin insulation layers and conductive layers are alternately laminated (see Fig. 6A).

Subsequently, on the outermost resin insulation layers 10U_{N} and 10L_{N} (the lowermost resin insulation layers) of each laminated sheet body 17U and 17L, as well as on the conductive circuit 19U_{N} and 19L_{N}, and the via conductor 14U_{N, M/2+1}, 14U_{N, M/2}, 14L_{N, 1}, and 14L_{N, M} formed on the second surface of the lowermost resin insulation layers, the solder resists 20L and 20U are formed. In this time, the surfaces of the lowermost resin insulation layers and the surfaces of the conductive circuits formed on the second surfaces of the lowermost resin insulation layers are all preferred to be roughened.

Here, the surfaces of the resin insulation layers and the surfaces of the conductive circuits are preferably roughened separately. For example, the surfaces of the above resin insulation layers are roughened by immersing the laminated sheets formed in the above into potassium permanganate aqueous solution. Also, the above conductive circuits may be roughened by using the above-described "CZ series" micro etching solution.

Next, by exposing to light and developing the solder resist, the openings for exposing the surfaces of the conductive circuits 19U_{N} and 19L_{N}, and the via conductors 14U_{N, M/2+1}, 14U_{N, M/2}, 14L_{N, 1}, and 14L_{N}, _{M} are arranged (see Fig. 6A). The surfaces of the conductive circuits and the via conductors exposed through the openings in the solder resists become the second pads (the second external connection terminals). Then, on the second external connection terminals (the second pads), the solder member (the solder bump) or pins are formed, through which electrical connection is made to other board.

The openings formed in the solder resists may be formed so as to expose the surfaces of via conductors and portions of the conductive circuit (the via land) connected to the via conductors. In such a case, the portions of the conductors exposed through the openings in the solder resist will structure the second pads.

Next, in order to release the laminated sheet body 17U, which is composed of the metal foil 11U, a plurality of the resin insulation layer 10U₁ to 10U_{N}, a plurality of the conductive layer 19U₁ to 19U_{N}, 14U_{1,1} to 14U_{N, M/2+1}, 14U_{1, 2} to 14U_{N, M/2} and the solder resist 20U; and the laminated sheet body 17L, which is composed of the metal foil 11L, a plurality of the resin insulation layer 10L₁ to 10L_{N}, a plurality of the conductive layer 19L₁ to 19L_{N}, 14L_{1, 1} to 14L_{N, 1}, 14L_{1, 2} to 14L_{N}, _{M} and the solder resist 20L from the support member SM respectively, the laminate is cut along the cutting lines A1 and A2, which are arranged inside the adhered regions AD joined by ultrasonic sound (see Fig. 6B). By this, the above two laminated sheet bodies are separated from the support member SM.

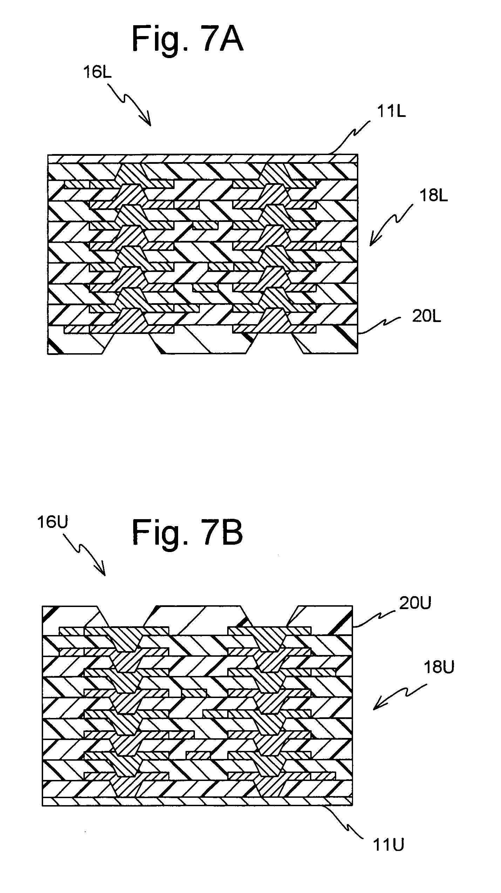

As a result, the intermediate substrate 18L shown in Fig. 7A and the intermediate substrate 18U shown in Fig. 7B are obtained. By using the above-mentioned procedure, the intermediate substrates 18U and 18L formed simultaneously on both surfaces of the support member SM may be obtained simultaneously.

Hereinafter, steps for manufacturing the printed wiring board 100 from intermediate substrate 18L are described. On the intermediate substrate 18L removed from the support member SM, the opposite surface to that on which the solder resist 20L is formed (the first surface of the uppermost resin insulation layer), is covered by the metal foil 11L (see Fig. 7A).

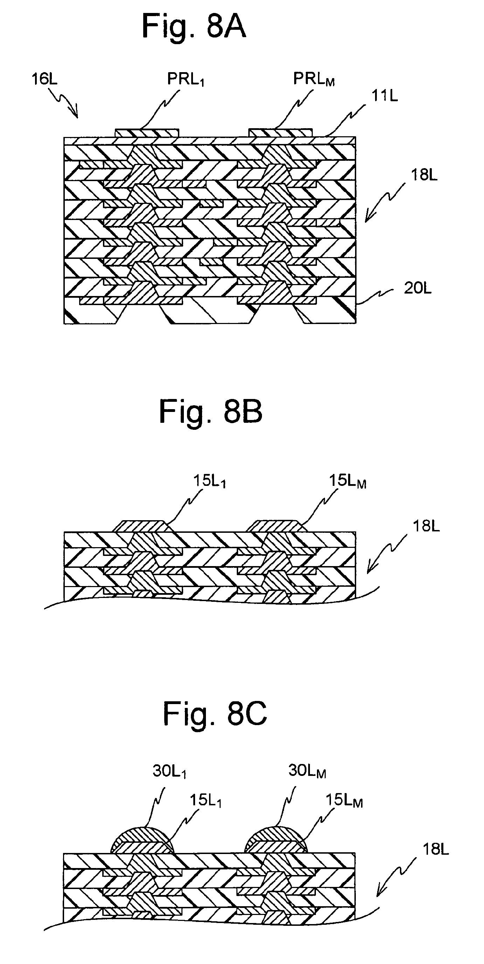

On the metal foil 11L, the dry film resist for etching is laminated, and then the resist is subjected to exposure and development by using a proper mask to form the resist patterns PRL₁ to PRL_{M} (see Fig. 8A).

Next, as shown in Fig. 8B, by using an etching solution (an etchant) containing copper (II) chloride or iron (II) chloride, portions of the metal foil, which exclude the area where the resist pattern is formed, are removed to form the first pads 15Lₖ (k=1∼M) on the first surface of the uppermost resin insulation layer. By forming the component-loading pads (the first pads) from the copper foil, uniform thickness of each pad may be easily achieved. Also, since the first pads are formed using the resist as an etching mask, different from the conventional methods, the electroplating layer may have no overhang from the pad at its top surface.

In this time, in order to protect the second external connection terminals from the etchant, the surface of the solder resist and the openings are preferred to be covered by the above-described resist.

On the surfaces of the first pads 15Lₖ (including the side surfaces of the first pads) formed above, a protective film composed of at least one layer of the electroless deposition film is formed. When forming the protective film composed of one layer, for example, electroless Au-deposition film or Pd-deposition film is formed on the pads. When forming the protective film composed of two layers, for example, electroless nickel-deposition film and then electroless gold-plating film are sequentially formed on the pads. When forming the protective film composed of three layers, between the above electroless nickel-deposition film and gold-plating film, an electroless Pd-deposition film is formed.

Prior to form the protective film on the first pads, the resist on the solder resist may be removed and the protective film may be formed on the second external connection terminals.

On the surfaces of the first pads (the first external connection terminals) 15Lₖ and the second pads (the second external connection terminals), instead of the protective film made of electroless deposition film, a water-soluble OSP film (Organic Solderability Preservative) may be formed. By forming the protective film or an OSP film, corrosion resistance and solderability of them may be improved.

When the OSP film is formed on the pad, since the OSP film is a very thin monomolecular film, the thickness of the component-loading pad composed of the component-loading pad (the first pad) and the protective film practically equals that of the component-loading pad. Furthermore, after the component-loading pads are formed, the protective film is formed on their surfaces, and thus, the protective film formed on the top surfaces of the pads does not have overhang from the pads.

Next, on the first pads 15Lₖ, for example, solder paste is printed by screen-printing. Since the component-loading pads (the first pads) are shaped truncated as described above, the protective film is formed so as to cover all surfaces of the pads (top surfaces and side walls). Therefore, the solder members (the solder bumps) spread out on the top surfaces and side walls of the first pads by wetting. Then, an electronic component, for example, an IC chip and so forth is mounted via the solder bumps formed on the first pads.

Next, as shown in Fig. 8C, by reflow soldering, solder bumps 30Lₖ are formed to mount an IC chip or the like.

On the second pads, solder bumps are formed in the same manner as above to connect to, for example, another board such as the mother board. As described above, the printed wiring board of the present invention is manufactured.
In the above-described printed wiring board according to the embodiment of the present invention, solder resist having openings to expose the first pads may be formed on the uppermost resin insulation layer and the first pads.

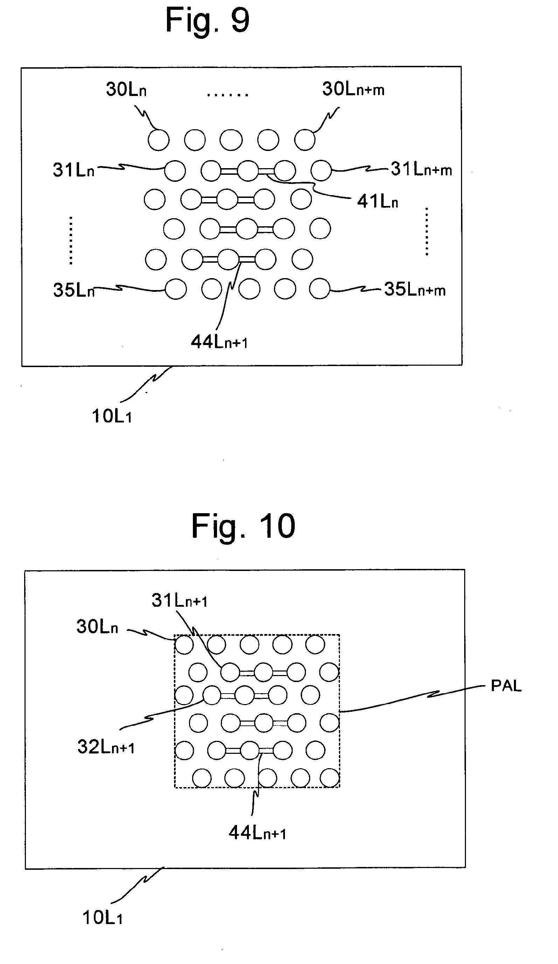

Also, the first pads may be arranged on the uppermost resin insulation layer 10L₁ as shown in Fig. 9, and then connected with each other by the inner conductive circuit 44Lₙ₊₁. When the first pads are formed as described above, PAL shown in Fig. 10 becomes the pad-forming region (the pad-forming region for component-loading pads). Those pads may be used as, for example, 30Lₙ for signals, 32Lₙ₊₁ for ground and 31Lₙ₊₁ for power supply. Here, the pad-forming region for component-loading pads is the region which is shaped rectangular (includes both square and rectangle) or circular (includes both round and ellipse) with a minimum area to include all the pads.

As shown in Fig. 9, the component-loading pads include the component-loading pads for the power supply and these for the ground. In the pad-forming region for the component-loading pads, it is preferred that at least either the inner conductive circuit for the power supply 41Lₙ, which electrically connects the component-loading pads for the power supply, or the inner conductive circuit for the ground 4Lₙ₊₁, which electrically connects the component-loading pads for the ground be formed.

Fig. 10 is an overhead view of the uppermost resin insulation layer. As shown in the figure, in the printed wiring board according to an embodiment of the present invention, the conductive circuit to be drawn from the pads is preferred not to be extended toward the periphery of the substrate on the uppermost resin insulation layer. It is preferred that the component-loading pads arranged on the uppermost resin insulation layer be formed in the pad-forming region; and that in the region excluding the pad-forming region, the surface of the uppermost resin insulation layer be exposed.

The above-described printed wiring board according to the embodiment of the present invention does not have a core substrate such as a conventional example does. Generally, without the core substrate, the stiffness of the printed wiring board may be lowered, or the thermal expansion coefficient may become large. As a result, large stress concentrates on the solder bumps connecting the electronic component and the printed wiring board, causing problems with connection reliability.

However, in the above-described printed wiring board according to the embodiment of the present invention, since the solder bumps are formed on the top surfaces and side walls of the first pads, the bonding strength between the solder members and the component-loading pads becomes higher. As a result, the solder members are seldom released from the component-loading pads. Thus, without the core substrate, the connection reliability between the IC chip and the pads would not be disrupted. At least the side surfaces of the first pads (the component-loading pads) are preferred to be roughened, because the bonding strength between the pads and the solder bumps is further improved.

Also, when the solder bump is formed even on the side surfaces of the pad of which having a rectangular cross-sectional shape, the distance between solder bumps becomes shorter. However, the cross-sectional shape of the component-loading pad (seen in the direction perpendicular to the surface of the uppermost resin insulation layer) is frustum as shown in Fig. 8B. Thus, if the solder bump is formed on the side walls of the first pad, the distance between adjacent solder bumps may be maintained widely.

Also, the surface of the uppermost resin insulation layer is roughened as described above. Thus, the wettability of the underfill improves and the charging efficacy of the underfill becomes higher. By this, the bonding strength between the underfill and the uppermost resin insulation layer may be improved.

### [Modified embodiments]

The present invention is not limited to the embodiment described above, and it may be modified in various ways.
In the embodiment described above, the metal foil (FU, FL) being components of the support member SM and other metal foil (11U, 11L) are joined by using ultrasonic sound. However, the method for joining the metal foil is not limited to it. As long as the metal foil are fixed each other, during the manufacturing process from the first step to that of the separation of the metal foil each other (see Figs.2A to 7B), other joining methods may be used. For example, the fixation method by using an adhesive agent, soldering, and the like may be used.
When the support member SM and the metal foil are fixed by using the adhesive agent, S, the component of the support member SM, may be made of either insulation material or non-insulation material. The support member SM may be the metal plate or the board having the metal foil covering its surfaces.

As the support member SM, when a fiber reinforced plastic (FRP) board with the metal foil laminated on each surface of the board, the metal foil (11U, 11L) is respectively laminated on each surface of the support member SM, and then the metal foil, and the support member SM are secured by using the adhesive agent at the peripheral portions. After that, according to the steps shown in Fig.3C or later, the printed wiring board is manufactured.
Also, when the adhesive agent is used as described above, the adhesive agent satisfying the requirement described below is preferably used.

(a) In each process shown in Figs. 2C through 7B, the metal foil (11U, 11L) is not peeled from the support member SM. During the insulation layer to be formed on the metal foil is cured, shrunk, or the like, the metal foil (11U, 11L) must not be deformed by deflection, fracture, bending, distortion and the like, or break.
(b) Solutions and others to be used in each step shown in Figs. 2C through 7B must not be polluted in the steps.
   Complying with the requirements of (a) and (b) described above, the resin, which is not softened or melted at the temperature employed in the processing steps shown in Fig.2C through 7B, is chosen.

Furthermore, when the support member SM and the metal foil (11U, 11L) are joined in not only their peripheral portions but also their entire surfaces, the adhesive agent that satisfies the requirement that capable of release of the intermediate substrates 18U, 18L from the support member SM at lower temperature at which the printed wiring board is deteriorated is preferably used.
Concretely, the thermoplastic resin, which has characteristics such that it is not softened or melted at the temperature employed in each step from Figs. 2C to 6B for processing (for example, 180°C), but softened or melted at the temperature not higher than it at which the intermediate substrate is deteriorated or soldering is carried out (for example, 280°C).

Instead of ultrasonic sound bonding used in the embodiment described above, the support member SM and the metal foil (11U, 11L) may be joined by using soldering. However, when soldering is employed, the bonded parts are exposed to higher temperature. In order to avoid that such thermal damage spread out the region on which wires are arranged in the printed wiring board, soldering is preferably to be carried out not entirely but partially.

According to the examples or the modified embodiment of the present invention, the bond strength between the support member SM and the metal foil (11U, 11L) is maintained by joining them from the first step to that in which the intermediate substrate is released. Therefore, the metal foil (11U, 11L) is saved from its deformation (for example, distortion, deflection, fracture, and bending) or breakage generated in the curing or contraction of the insulation layer. As a result, the printed wiring board having excellent connection reliability between pads (C4 pad) formed from the metal foil and the via conductors is manufactured. Also, the printed wiring board having excellent connection or accuracy position of pads formed from the metal foil is manufactured.

### Examples

Hereinafter, the present invention is described in detail according to examples. However, the present invention is not limited to those examples.

### [Example 1] Manufacturing of a printed wiring board

### (1) Manufacturing a base substrate BS

As for the support member SM, double-sided copper-clad laminate SM (item number: MCL-E679 FGR, made by Hitachi Chemical Co., Ltd.), where 18 µm- thick copper foils FU and FL are laminated on both surfaces of 0.4 mm-thick glass epoxy board, was used (see Fig. 2A).

Next, as shown in Fig. 2A, on the both surfaces of the double-sided copper-clad laminate SM, the first surfaces of 18 µm-thick copper foils 11U and 11L were laminated. The copper foil 11U and 11L has one matted surface (a roughened surface), which is designated as the second surface (a roughened surface). Next, a horn of an ultrasound bonding equipment was set so as to bond the copper foil and the double-sided copper-clad laminate at the positions 20 mm inside from each edge. Then, under the following conditions, the horn was moved along the four sides to bond the copper-clad laminate and the copper foil (see Figs. 2C and 2D).

horn amplitude: approximately 12 µm
number of oscillations of horn: f=28 kHz
pressure of horn exerted on copper foil: p=approximately 0-12 kgf
feed rate of horn along copper foil: v=approximately 10 mm/sec
Figs. 2B and 2C show the secured portions of the double-sided copper-clad laminate and the metal foil. The secured portions are located 20 mm inside from each edge of the metal foil toward the center, and the width of the secured portions is 2 mm.

Next, on the copper foil, etching resists were formed by using a commercially available product, then exposed to light and developed. Then, as shown in Figs. 3A and 3B, the etching resists were patterned to overlap the bonded portions (AD).

Next, through a tenting process using an etching solution containing copper (II) chloride or others, portions of sheets of the copper foil FU and 11U, as well as FL and 11L where etching resists were not formed were removed. Then, by conventional procedure, the etching resists were removed and base substrate BS was manufactured.

### (2) Forming a laminated sheets through a build-up process

On each surface (the second surface of the metal foil) of the base substrate BS manufactured as above, an interlaminar film for build-up wiring ("ABF series," made by Ajinomoto Fine-Techno Co., Inc.) was laminated and thermoset at about 170°C for 180 minutes to form resin insulation layers (the uppermost resin insulation layers) 10U and 10L.
Then, as shown in Fig. 4A, openings for via holes were formed by using a carbon dioxide gas laser.

Next, the surfaces of the resin insulation layers were roughened by using a 50g/L potassium permanganate solution at 50-80°C for 1-5 minutes. Then, electroless copper-deposition was performed using a commercially available plating bath to form electroless copper-deposition films (chemical copper deposition films) with a thickness in the range of approximately 0.3-1 µm as shown in Fig. 4B.

Next, a commercially available dry film was laminated. After that, as shown in Fig. 5A, plating resists were patterned by a photographic method.

Copper electroplating was performed using the electroless copper-deposition films formed on the resin insulation layers as electrodes to form 5-20 µm-thick copper electroplating films on the electroless copper-deposition films where the plating resists were not formed. Then, the plating resists were removed.

Next, as shown in Fig. 5B, the electroless copper-deposition films located between the copper electroplating films were removed to form conductive circuits 19U, 19L and via conductors 14U,14L. Here, the via conductors were formed so as to fill the openings formed in the resin insulation layers and to make their top surfaces flush with the top surfaces of the conductive patterns formed on the same resin insulation layers.

The above steps were repeated eight times to form laminates 17U and 17L having eight (8) resin insulation layers and eight (8) conductive layers (see Fig. 6A).

### (3) Forming the second external connection terminals (the second pads)

In the laminated sheets 17U and 17L composed of the eight layers, the surfaces of the lowermost resin insulation layers 10U_{N}, 10L_{N} (the resin insulation layers formed opposite the support board) and the surfaces of the conductive patterns formed on the resin insulation layers were roughened. In order to roughen the surfaces of the resin insulation layers, the laminates formed here were immersed in a permanganate aqueous solution. Also, in order to roughen the conductive circuits, the above-described "CZ series" was used.

Next, on the lowermost interlayer resin insulation layers and the conductive circuits formed on the lowermost interlayer resin insulation layer, the solder resist 20U and 20L were formed using a commercially available product. Then, the masks were laminated on the solder resists, and openings were formed by a photolithographic method in the solder resist 20U and 20L. The surfaces of the via conductors and the surfaces of the conductive patterns exposed through the openings were made into the second external connection terminals (see Fig. 6A).

### (4) Releasing from the support member SM and forming the first external connection terminals (the first pads)

The cutting sections were set so as to positions just inside the bonded portions (see A1 and A2 in Fig. 6B), and cutting was conducted at those sections. Then, laminated sheets 17U and 17L were released from the support member SM to make the intermediate substrates 18U, 18L respectively (see Figs. 7A, 7B).

On the copper foil 11L of the intermediate substrate 18L which was released from the support member SM and exposed, the commercially available dry film for etching resist was laminated. Then, the etching resist was patterned by the photographic method (see Fig. 8A).

To protect the second pads formed in solder resist 20L from the etchant, an etching resist the same as above was laminated to cover the entire surface of the solder resist 20L and the openings.

Next, using the etching solution mainly containing copper (II) chloride and under a spray pressure of 0.3-0.8 MPa, etching was conducted to remove the portions of the copper foil on which the etching resist was not formed, and then the first pads were formed. The shape of the first pads 15Lₖ (k=1∼M) was frustum, as shown in Fig. 8B; wherein the area of the bottom surface contact with the first surface of the uppermost resin interlayer insulation layer 10L₁ was larger than that of the top surface on which to mount an electronic component.

Also, as described above, the uppermost insulation layer was formed on the roughened surface of the copper foil. Therefore, after the copper foil was removed by etching, thereby a roughened surface copied from the roughened surface of the copper foil was formed on the first surface of the uppermost resin insulation layer.

Next, as shown in Fig. 8B, the etching resist was removed to form a group of pads containing a plurality of the component-loading pads (the first pads). Since component-loading pads (the first pads) were formed from copper foil 11L, the thickness of each pad was made substantially uniform. Also, since the first pads were formed using the resist as an etching mask, at the top surface of a pad an electroplating layer overhang from the pad was not formed.

### (5) Surface treating of the pads

After forming the first pads, the surfaces of each first pad and the second pad were finished by the OSP (Organic Solderability Preservative) to form the protective film. By this, the very thin monomolecular protective film was formed on the pads, and the thickness of a component-mounting pad composed of the component-loading pad (the first pad) and the protective film was practically equal to the thickness of the pad. Also, after forming the first pads, the protective film was formed on their surfaces, and thus the protective film formed on the top surface of a pad did not have overhang from the pad.

### (6) Forming solder bumps

Next, as shown in Fig. 8C, by the screen printing method, the solder paste was printed on the first pads and the second pads, and conducted by the reflow-soldering to form the solder bumps on the first and the second pads (the solder bumps on the second pads were not shown in Fig. 8C). Since the protective film was formed on the entire surface of the first pads (the top surfaces and the side walls), the solder bump were formed by solder spread out over the top surfaces and the side walls by wetting.

Although the embodiment of the present invention does not have the core substrate, the bonding strength between the solder bumps and the first pads became higher, because the solder bumps were formed on the top surfaces and side walls of the first pads. As a result, the solder bumps were seldom released from the first pads.
Also, since the cross-sectional shape of the first pads was frustum, the distance between adjacent solder bumps is substantially the same as the distance between the pads, thus maintained wide.

Also, in Example 1, on the uppermost resin insulation layer and on the first pads, a solder resist having openings to expose the first pads was not formed. Therefore, in contrast with a printed wiring board having the solder resist, the distance between the surface of the uppermost resin insulation layer and an IC chip was large. As a result, the filling ratio of an underfill to seal between the IC chip and the printed wiring board was improved.

Also, since the surface of the uppermost resin insulation layer was roughened as described above, the wettability of the underfill became higher and the filling ratio of the underfill was improved. Thereby, the bonding strength between the underfill and the uppermost resin insulation layer was improved.

### [Example 2]

As the support member SM, the double-sided copper-clad laminate, on which 5 µm-thick copper foil FU and FL are laminated on each surface of 0.4 mm-thick fiber-reinforced plastics, was used. On the copper foils FU and FL, a copper foil was secured by an epoxy-type adhesive agent, and otherwise was the same as in Example 1 to form a printed wiring board.

### [Example 3]

In stead of the OSP film formed on both of the first and the second pads in Example 1 as the protective film; plating films composed of electroless nickel-plating film and an electroless gold-plating film were carried out sequentially in this order were formed on the surfaces of both first and second pads to use it as the protective film.

Except the points were the same as in Example 1 to form a printed wiring board. In this example, in order to achieve a uniform thickness of the protective film formed on each first pad, a protective film was formed not by electroplating, but by electroless deposition. Also, electronic component-mounting pads were composed of the electronic component-loading pads and the protective film formed with the electroless deposition film. As a result, the distance between electrodes of the electronic component and electronic component-mounting pads became uniform.

### [Example 4]

Instead of the copper foils 11U and 11L used in Example 1 to form the first pads in Example 1, a copper foil having the first smooth surface and the second matted surface was used. Also, the side surfaces of the first pads were roughened after the first pads were formed but before the etching resist was removed. Except the points were the same as in Example 1 to form a printed wiring board. As a result, the first pads in Example 4 had smooth top surfaces and roughened side walls.

### [Example 5]

The protective film formed in Example 1 was formed neither on the first pads nor on the second pads. Except the points were the same as in Example 1 to form a printed wiring board.
Since the first pads were formed only with the copper foil, the thickness of each first pad was uniform. As a result, uniform distance between each electrode of the electronic component such as the IC and each first pad, as well as a reduced amount of solder for use to form solder bumps, was achieved. As a result, a reduction in the connection resistance between the printed wiring board and the electronic component was achieved.

### [Example 6]

In Example 5, in order to improve the joining strength between the solder bumps and the first pads, the CZ treatment was conducted to roughen the surfaces of the first pads. Thereby the top surfaces and side walls of the first pads became roughened. Except the points were the same as in Example 1 to form a printed wiring board.

### [Example 7]

In Example 6, on both of the first and the second pads, the protective film formed with an electroless gold-deposition film was formed. Except the points were the same as in Example 1 to form a printed wiring board.

### [Example 8]

In Example 6, on both of the first and the second pads, the protective film was formed using the OSP. Except the points were the same as in Example 1 to form a printed wiring board.

### [Example 9]

In example 9, FRP board employed in Example 2 is used as the support member. Copper foil is laminated on each surface of the FRP board, and then peripheral portions of the copper foil were secured on the support member by using the epoxy type adhesive agent. Then, the printed wiring board is manufactured according to the steps shown on Figs.3C and later in Example 1.

### Industrial Applicability

As described above, a flexible printed wiring board according to the present invention is useful as a thin printed wiring board. It is suitable to use for manufacturing smaller devices.

Furthermore, the flexible printed wiring board according to the present invention is suitable to manufacture the thin printed wiring board having excellent connection reliability with a high yield ratio.

## Claims

1. A printed wiring board, comprising:
a plurality of resin insulation layers each having openings for via conductors;
a plurality of conductive layers each having a conductive circuit;
via conductors formed in the openings and connecting conductive circuits formed in separate conductive layers among the conductive layers; and
a plurality of component-loading pad for loading an electronic component formed on an uppermost resin insulation layer positioned as an outermost layer of the plurality of resin insulation layers, wherein
the resin insulation layers and the conductive layers are alternately laminated, and the component-loading pads are formed from a copper foil.

2. The printed wiring board according to Claim 1, wherein the component-loading pads have a frustum form, in which an area of a bottom surface touching a surface of the uppermost resin insulation layer is made larger than the area of a top surface on which to load an electronic component.

3. The printed wiring board according to Claim 1, wherein solder members are formed on the top surfaces of the component-loading pads on which the electronic component is mounted, and on a side surfaces of the component-loading pads.

4. The printed wiring board according to Claim 3, wherein the side surfaces of the component-loading pads are roughened.

5. The printed wiring board according to Claim 1, wherein a conductive circuit drawn from the pad toward the periphery of a resin insulation layer on the substrate is not formed on the uppermost resin insulation layer.

6. The printed wiring board according to Claim 1, wherein the component-loading pads arranged on the uppermost resin insulation layer are formed in a pad-forming region, and in the region excluding the pad-forming region the surface of the uppermost resin insulation layer is exposed.

7. The printed wiring board according to Claim 1, wherein a protective film is formed on the top surfaces and side surfaces of the component-loading pads.

8. The printed wiring board according to Claim 1, wherein the interlayer resin insulation layer is an insulation layer containing filler excluding glass cloth and continuous glass fiber.

9. The printed wiring board according to Claim 1, wherein the component-loading pads comprise a component-loading pad for a power supply and a component-loading pad for ground; and
in the pad-forming region for forming component-loading pads, at least one inner conductive circuit selected from a group consisting of the circuit for power supply that electrically connects each component-loading pad for power-supply and the circuit for ground that electrically connects each component-loading pad for ground is formed.

10. A method for manufacturing a printed wiring board, comprising the steps of:
securing a metal foil to a support board by joining or bonding;
forming a resin insulation layer on a metal foil;
forming an opening for a via conductor in the resin insulation layer;
forming a conductive circuit on the resin insulation layer;
forming a via conductor that electrically connects the conductive circuit and the metal foil in the opening;
separating the support member and the metal foil; and
forming an external terminal from the metal foil, wherein the terminal electrically connects to a different board or an electronic component.

11. The method for manufacturing a printed wiring board according to Claim 10, wherein the conductive circuit and the via conductors are formed simultaneously.

12. The method for manufacturing a printed wiring board according to Claim 10, wherein securing the metal foil and the support member is conducted by joining or bonding peripheral portions of the metal foil to the support member.

13. The method for manufacturing a printed wiring board according to Claim 10, further comprising the steps of:
forming an upper-layer resin insulation layer to cover the resin insulation layer and the conductive circuit;
forming an opening for the upper-layer via conductor in the upper-layer resin insulation layer;
forming an upper-layer conductive circuit on the upper-layer resin insulation layer; and
forming an upper-layer via conductor in the upper-layer openings, wherein the via conductor electrically connects the conductive circuit and the upper-layer conductive circuit.

14. The method for manufacturing a printed wiring board according to Claim 13, wherein the upper-layer conductive circuit and the via conductor is formed simultaneously.

15. The method for manufacturing a printed wiring board according to Claim 10, wherein the support member is a metal plate or a plate member composed of a support base member and a metal covering the surface of the support base member.

16. The method for manufacturing a printed wiring board according to Claim 15, wherein the metal is a metal foil.

17. The method for manufacturing a printed wiring board according to Claim 16, wherein the support member and the metal foil are secured by ultrasonic sound bonding.

18. The method for manufacturing a printed wiring board according to Claim 15, wherein the support member is a copper-clad laminate.

19. The method for manufacturing a printed wiring board according to Claim 18, wherein the support member and the metal foil are secured by using ultrasonic sound bonding.
